# EUROPÄISCHE PATENTSCHRIFT

(11) **EP 2 976 787 B1**
(45) Veröffentlichungstag und Bekanntmachung des Hinweises auf die Patenterteilung: **31.07.2019**
(21) Anmeldenummer: 14706056.0
(22) Anmeldetag: 25.02.2014
(51) Int. Cl.: H01L 29/861, H01L 29/06

(54) **GLEICHRICHTERDIODE**
RECTIFIER DIODE
DIODE DE REDRESSEMENT

(30) Priorität: 18.03.2013 DE 102013204701
(43) Veröffentlichungstag der Anmeldung: 27.01.2016
(73) Patentinhaber: Robert Bosch GmbH, 70442 Stuttgart (DE)
(72) Erfinder: GOERLACH, Alfred, 72127 Kusterdingen (DE)
(86) Internationale Anmeldenummer: PCT/EP2014/053596
(87) Internationale Veröffentlichungsnummer: WO 2014/146870

(56) Entgegenhaltungen:
- DE-A1-102004 053 760
- US-A- 5 818 084
- US-A1- 2009 315 083
- US-B1- 7 615 812

## Beschreibung

### Stand der Technik

Bei Kfz-Drehstrom- oder Wechselstromgeneratoren (Lichtmaschinen) werden zur Gleichrichtung Wechselstrombrücken (Gleichrichter) verwendet. Als gleichrichtende Elemente werden meist Halbleiterdioden mit einem pn-Übergang aus Silizium eingesetzt. Beispielsweise werden bei einem Drehstromgenerator sechs Halbleiterdioden zu einer B6-Brücke zusammengeschaltet. Gelegentlich werden auch Dioden parallelgeschaltet und beispielsweise zwölf anstatt sechs Dioden verwendet. Bei Wechselstromgeneratoren mit anderer Phasenzahl werden entsprechend angepasste Diodenbrücken eingesetzt.

Die Dioden sind für einen Betrieb bei hohen Strömen bzw. Stromdichten bis über 500 A/cm² und hohen Temperaturen bzw. einer maximalen Sperrschichttemperatur Tj von etwa 225°C ausgelegt. Typischerweise beträgt der Spannungsabfall in Flussrichtung, d.h. die Flussspannung UF, bei den verwendeten hohen Strömen ca. 1 Volt. Bei Betrieb in Sperrrichtung unterhalb der Durchbruchsspannung UZ fließt in der Regel nur ein sehr kleiner Sperrstrom IR. Ab der Durchbruchsspannung UZ steigt der Sperrstrom stark an. Ein weiterer Spannungsanstieg wird deshalb verhindert. Meist finden in diesem Zusammenhang Z-Dioden mit Sperrspannungen - je nach Bordnetzspannung des jeweiligen Kraftfahrzeugs - von ca. 20 - 40 Volt Verwendung. Z-Dioden können im Durchbruch kurzzeitig mit hohen Strömen belastet werden. Sie werden deshalb zur Begrenzung der überschießenden Generatorspannung bei Lastwechseln eingesetzt. Solche Dioden sind üblicherweise in robusten Einpressdiodengehäusen verpackt, wie es beispielsweise in der DE 195 49 202 B4 beschrieben ist.

Die Flussspannung von pn-Dioden führt zu Durchlassverlusten und damit zu einer Wirkungsgradverschlechterung des Generators. Da bei der Stromabgabe des Generators im Mittel immer zwei Dioden in Reihe geschaltet sind, betragen die mittleren Durchlassverluste bei einem 100 A-Generator etwa 200 W. Diese Verluste führen zu einer Aufheizung der Dioden. Die entstehende Wärme muss durch aufwendige Kühlmaßnahmen am Gleichrichter abgeführt werden, beispielsweise unter Verwendung von Kühlkörpern und/oder eines Lüfters.

Zu einer Reduktion der Durchlassverluste wird in der DE 10 2004 056 663 A1 vorgeschlagen, an Stelle von pn-Dioden sogenannte Hocheffizienz-Schottky-Dioden (HED) zu verwenden. Als Hocheffizienz-Schottky-Dioden werden dabei Dioden bezeichnet, bei denen im Gegensatz zu herkömmlichen Schottky-Dioden der Sperrstrom nahezu unabhängig von der Sperrspannung ist. Hocheffizienz-Schottky-Dioden bestehen aus einer monolithisch auf einem Halbleiterchip integrierten Kombination einer herkömmlichen Schottky-Diode (SBD) und weiteren Elementen, beispielsweise Feldplatten, pn-Übergängen oder unterschiedlichen Barrieremetallen. Hocheffizienz-Schottky-Dioden sind häufig in Trenchtechnik ausgeführt. Neben der geringen Flussspannung im Durchlassfall begrenzen sie ebenfalls die überschießende Generatorspannung, die bei plötzlichen Lastwechseln auftreten kann, auf unkritische Werte, bei 14 V-Systemen typischerweise auf Spannungen unter 30 V.

Mit Hocheffizienz-Schottky-Dioden können wesentlich niedrigere Flussspannungen UF im Bereich von 0,5 V bis 0,7 V realisiert werden. Durch die geringen Durchlassverluste der Dioden erhöhen sich der Wirkungsgrad und die Abgabeleistung des Generators. In Folge der niedrigeren Sperrverlustleistungen kann zudem der Aufwand für die Kühlung gegenüber dem Einsatz von pn-Dioden deutlich reduziert werden.

Eine Herstellung von Hocheffizienz-Schottky-Dioden ist aufwendig und technisch sehr anspruchsvoll. Neben den sehr feinen Grabenstrukturen mit Mesaweiten im Bereich unterhalb 500 nm, die in das Silizium geätzt werden müssen, stellt insbesondere die kostengünstige Herstellung von geeigneten und stabilen Schottky-Kontakten eine Herausforderung dar. Als Schottky-Kontakte finden bevorzugt Nickelsilizide oder andere geeignete Silizide Verwendung. In modernen Halbleiterwerken, die Leistungs-MOSFETs produzieren, stehen diese Silizidprozesse meist nicht zur Verfügung.

In der DE 10 2010 062 677 A1 wird vorgeschlagen, an Stelle von Hocheffizienz-Schottky-Dioden sogenannte Pseudo-Schottky-Dioden (PSD) einzusetzen. Dabei handelt es sich um speziell hergestellte n-Kanal MOSFETs mit extrem niedriger Schwellenspannung Vth, bei denen Gate, Body- und Sourcegebiet fest elektrisch miteinander verbunden sind und als Anode dienen, während das Draingebiet als Kathode fungiert. Bei einer Verwendung von Pseudo-Schottky-Dioden können ähnlich wie bei einer Verwendung von Hocheffizienz-Schottky-Dioden niedrige Flussspannungen sowie eine Spannungsbegrenzung realisiert werden. Die Spannungsbegrenzung erfolgt dabei mit Hilfe der eingebauten Bodydiode. Solche Bauelemente sind beispielsweise aus der US 5 818 084 bekannt. Diese Halbleiterbauelemente enthalten keine Schottky-Kontakte und benötigen deshalb auch keine speziellen Silizidprozesse. Sie können mit modifizierten Standardprozessen für MOSFETs hergestellt werden. Als Majoritätsträgerbauelemente schalten sie wiederum sehr schnell.

Pseudo-Schottky-Dioden werden in planarer Leistungshalbleiter-MOSFET-Technologie hergestellt. Dort findet der Avalanchedurchbruch bei der Spannung UZ im Inneren des Halbleiters an der sogenannten Bodydiode D statt. Beim Avalanche- oder Sperrspannungsdurchbruch werden heiße Ladungsträger (Elektronen und Löcher) generiert. Die Elektronen fließen zur Kathode, die Löcher direkt über das Bodygebiet zur Anode ab. Durch die spezielle Konstruktion der planaren MOSFETs ist sichergestellt, dass dabei keine heißen Löcher in das Gateoxid injiziert werden, sondern dass sie direkt über das Bodygebiet abfließen. Das Bauelement kann während eines Load-Dumps im Durchbruch betrieben werden und damit einen Spannungsanstieg begrenzen, ohne dass sein Gateoxid verändert wird bzw. das Bauelement Schaden nimmt.

Bei Pseudo-Schottky-Dioden mit dem betrachteten Sperrspannungsbereich fällt die Spannung in Durchlassrichtung, die Durchlassspannung UON, im Wesentlichen im Kanalbereich (Inversionskanal) ab. Um möglichst niedrige Durchlassspannungen zu erzielen sollte deshalb die Kanalweite bzw. die Anzahl der Kanäle bezogen auf die eingesetzte Chipfläche möglichst groß gewählt werden. Grundsätzlich kann die Zelldichte und damit die Kanalweite deutlich erhöht werden, wenn an Stelle von planaren Leistungs-MOSFETs, die in Trenchtechnik ausgeführt sind (TrenchMOSFETs), eingesetzt werden. Bei diesen Bauelementen findet der Avalanchedurchbruch aber bevorzugt am Boden der Trenchstruktur statt. Nachteilig ist dabei, dass die Löcher, die beim Avalanchedurchbruch erzeugt werden, durch das elektrische Feld beschleunigt und in das Gateoxid injiziert werden. Sie wirken dort wie fest in das Gateoxid eingebaute positive Ladungen. Dadurch verändern sich die Eigenschaften der Trench-MOS-Feldeffekttransistoren. Beispielsweise wird die Schwellenspannung VTH erniedrigt und die Sperrspannung erhöht. Besonders nachteilig wirkt sich die Variation bei Trench-MOS-Transistoren aus, die eine sehr niedrige Schwellenspannung aufweisen. Aus diesem Grund sind Pseudo-Schottky-Dioden, die auf Trench-MOS Konzepten beruhen, zur Spannungsbegrenzung nicht geeignet.

Ein weiterer Nachteil sowohl bei planaren- als auch Trench-Konzepten ist die bekannte Tatsache, dass der durch den Avalancheeffekt erzeugte Löcherstrom auf seinem Weg zum Sourcekontakt einen Spannungsabfall erzeugt und dabei den parasitären npn-Transistor, gebildet aus Source-, Bodygebiet und n-Epischicht aufsteuern kann. Die Folge ist ein abrupter Rückgang der Durchbruchsspannung (Snap Back), der zu einer Zerstörung des Transistors führen kann. Dieser Effekt ist bei hohen Temperaturen und hohen Durchbruchsströmen besonders ausgeprägt.

Weitere Schottky-Dioden sind aus der US 7,615,812 und der US 5,818,084 bekannt.

Die US 7,615,812 offenbart eine Pseudo-Schottky-Diode, die auf Trench-MOS Konzepten beruht und die weitere p-dotierte Schichten an den Trenchböden aufweist. Die weiteren p-dotierten Schichten sind in Kontakt mit der Polysiliziumschicht in den Gräben und erstrecken sich in die niedrig n-dotierte Drift-Schicht.

### Offenbarung der Erfindung

Eine Pseudo-Schottky-Diode mit den im Anspruch 1 angegebenen Merkmalen zeichnet sich dadurch aus, dass sie einen sehr niedrigen Spannungsabfall in Durchlassrichtung UON aufweist und trotzdem stabil im Sperrspannungsdurchbruch betrieben werden kann. Pseudo-Schottky-Dioden gemäß der Erfindung können als in Einpressdioden-Gehäuse verpackte Leistungshalbleiter zur Gleichrichtung in Kfz-Wechselstromgeneratoren verwendet werden.

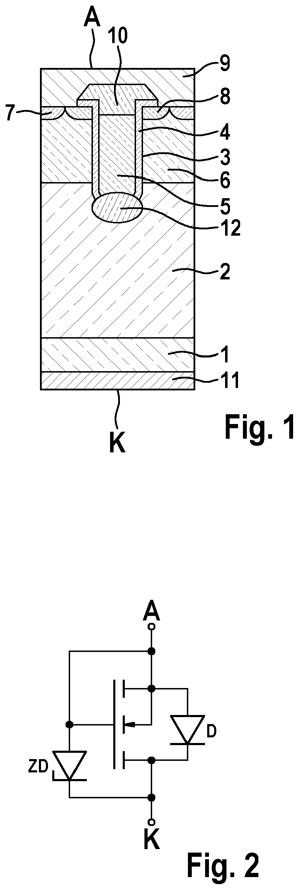

In Fig.1 ist ein Beispiel für eine Pseudo-Schottky-Diode im Querschnitt aufgezeigt, das das Verständnis der vorliegenden Erfindung erleichtert. Auf einem hoch n+-dotierten Siliziumsubstrat 1 befindet sich eine n-dotierte Siliziumschicht 2 (Epi-Schicht), in die eine Vielzahl von Gräben (Trenches) 3 eingebracht sind. In Fig.1 ist nur einer dieser Gräben exemplarisch dargestellt. Die gebildeten Zellen können dabei insel- oder streifenförmig oder auch andersartig geformt sein. An den Seitenwänden der in das Silizium eingeätzten Gräben 3 befindet sich jeweils eine extrem dünne, vorzugsweise aus Siliziumdioxid bestehende dielektrische Schicht 4. Im Gegensatz zu üblichen TrenchMOSFETs, bei denen diese Oxiddicke etwa 40 - 100 nm beträgt, ist die Oxiddicke bei einer erfindungsgemäßen Pseudo-Schottky-Diode wesentlich geringer und liegt vorzugsweise im Bereich von 5 nm bis 30 nm. Die Oxidschicht 4 ist an den Böden der Gräben 3 entfernt bzw. geöffnet. Das Innere der Gräben ist mit einem leitfähigen Material 5, beispielsweise mit p-dotiertem Polysilizium, gefüllt. Unterhalb der p-dotierten Polysiliziumschicht 5 am Trenchboden befindet sich jeweils eine weitere p-dotierte Siliziumschicht 12. Diese ist mit der p-dotierten Polysiliziumschicht 5 elektrisch verbunden und bildet mit der n-dotierten Epischicht 2 einen pn-Übergang 12-2. Die Dotierung und Eindringtiefe dieser weiteren p-dotierten Schicht 12 ist so gewählt, dass die Durchbruchsspannung des pn-Überganges 12-2 kleiner ist als die Durchbruchsspannung der verbleibenden Grabenstruktur, die aus den Schichten 5, 4 und 2 gebildet wird, und des Weiteren kleiner ist als die Durchbruchsspannung der Bodydiode (pn-Übergang 6-2). In den sich zwischen den Gräben befindenden p-dotierten Schichten 6 (Bodygebiet oder p-well) sind an der Oberfläche hoch n+-dotierte Bereiche 8 (Source) und hoch p+-dotierte Bereiche 7 eingebracht, die zum ohmschen Anschluss der Bodygebiete dienen. Die Oberfläche der gesamten Struktur ist mit einer geeigneten, leitfähigen Schicht 9, beispielsweise mit Aluminium oder AlSiCu, bedeckt, die mit den p+- bzw. n+-dotierten Schichten 7 und 8 einen ohmschen Kontakt bildet. Eine dicke dielektrische Schicht 10, beispielsweise eine CVD-Oxidschicht, isoliert jeweils die leitfähige Polysiliziumschicht 5 von der Metallschicht 9. Die Polysiliziumschichten 5 sind miteinander und an einer nicht eingezeichneten Kontaktstelle über die Metallschicht 9 galvanisch mit den hoch p+-dotierten Schichten 7 sowie den hoch n+-dotierten Schichten 8 verbunden. Auf der Rückseite des Chips befindet sich ebenfalls eine Metallschicht 11. Sie stellt den elektrischen Kontakt zum hoch n+-dotierten Siliziumsubstrat 1 dar. Die Metallschicht 9 bildet den Anodenkontakt A, die Metallschicht 11 den Kathodenkontakt K der Pseudo-Schottky-Diode.

Für die Metallschicht 9 bzw. die nicht eingezeichnete Kontaktstelle kann eine in der Siliziumtechnologie übliche Aluminiumlegierung mit Kupfer- und Siliziumanteilen (AlSiCu) oder ein sonstiges Metallsystem, beispielsweise AICu, über einer dünnen Barriereschicht aus TaN oder einem ähnlichen Material verwendet werden.

Zur Verpackung in Einpressdiodengehäuse sind Vorder- und Rückseite der Pseudo-Schottky-Diode jeweils zusätzlich mit einem lötfähigen Schichtsystem versehen. Beispielsweise ist über den Metallschichten 9 und 11 auf der Vorder- bzw. Rückseite ein nicht eingezeichnetes übliches lötfähiges Metallsystem, bestehend beispielsweise aus einer Schichtenfolge von Cr, NiV und Ag, aufgebracht.

Im Fall einer hohen Sperrspannung VKA begrenzt die Diode 12-2 am Grabenboden die Spannung. Der pn-Übergang 12-2 bricht durch (Avalanchedurchbruch). Da die dabei generierten Löcher über die weiteren p-dotierten Gebiete 12 und die dotierten Polysiliziumschichten 5 zur Anode abfließen, findet keine Ladungsträgerinjektion in die Oxidschichten 4 hinein statt. Die Kennlinie der Pseudo-Schottky-Diode und insbesondere auch deren Schwellenspannung VTH bleiben stabil. In Durchlassrichtung fließt nur wenig Strom über die Dioden ZD (pn-Übergang 12-2) und D (pn-Übergang 6-2), da die Durchlassspannung UON bei erfindungsgemäßen Pseudo-Schottky-Dioden kleiner als die Flussspannung von pn-Dioden ist. Im Gegensatz zu den Pseudo-Schottky-Dioden, wie sie in der DE 10 2010 062 677A1 beschrieben sind, findet der Sperrspannungsdurchbruch nicht an der Bodydiode D, sondern an den Dioden an den Grabenböden ZD statt.

Grundsätzlich erstrecken sich die weiteren p-dotierten Gebiete 12 gemäß der Erfindung bis in das hoch n+- dotierte Substratgebiet 1 hinein. Dann bestimmt der pn-Übergang 12-1 die Durchbruchsspannung.

Die Spannungsbegrenzung mittels der weiteren p-dotierten Gebiete 12 kann auch für Pseudo-Schottky-Dioden Verwendung finden, die zusätzliche Strukturen zur Ladungskompensation enthalten, beispielsweise Feldplatten, Trench-MOS-Transistoren, etc.

In der Fig. 2 ist ein einfaches Ersatzschaltbild einer Pseudo-Schottky-Diode aufgezeichnet. Der selbstsperrende n-Kanal MOSFET ist dabei so geschaltet, dass Gate, Bodygebiet und Sourcegebiet fest elektrisch miteinander verbunden sind und als Anode dienen. Das Draingebiet stellt die Kathode dar.

Liegt am Anodenanschluss A eine positive Spannung an (Durchlassrichtung), wird der MOS-Transistor im 3. Quadranten betrieben. Nach Überwindung der bei Pseudo-Schottky-Dioden üblicherweise sehr geringen Schwellenspannung von beispielsweise 0,3 V oder kleiner bildet sich ein Inversionskanal und es fließt Strom parallel zur integrierten Body-Diode D. Die Durchlassspannung UON ist kleiner als die Flussspannung UF der Bodydiode D. Da Gate- und Anodenpotential identisch sind, wird der MOSFET im Beginn der Sättigung betrieben, d. h. der Anodenstrom steigt etwa quadratisch mit der Flussspannung UON an.

Liegt am Kathodenanschluss K eine positive Spannung gegenüber der Anode A an (Sperrrichtung), sperrt der MOSFET, da sich sein Gate auf Sourcepotential befindet. Abgesehen von einem geringen Sperrstrom ist der Stromfluss unterbunden. Im Fall einer hochschießenden Generatorspannung, wie sie bei einem Load Dump bzw. einer Lastabschaltung auftritt, wird die Spannung bei einer herkömmlichen Pseudo-Schottky-Diode auf Basis eines planaren MOSFETs von der Bodydiode D begrenzt. Die Bodydiode D eines planaren MOSFETs wird als Z-Diode verwendet und begrenzt die Spannung. Im Gegensatz dazu wird die Spannung bei einer erfindungsgemäßen Pseudo-Schottky-Diode durch die Diode ZD am Grabenboden begrenzt. Bei einer erfindungsgemäßen Pseudo-Schottky-Diode findet der Sperrspannungsdurchbruch also nicht an der Bodydiode D, sondern an der Diode ZD am Grabenboden statt. Damit können Überspannungen im Fehlerfall begrenzt werden. Steigt die Spannung über die Durchbruchsspannung UZ der Bodydiode an, bricht die Diode durch (Avalanche- bzw. Lawinendurchbruch) und verhindert so einen weiteren Spannungsanstieg. Da die erzeugten Löcher direkt über die Gate-Polysiliziumschicht 5 zur Anode abfließen, kann keine schädliche Injektion von heißen Ladungsträgern in die Oxidschicht 4 stattfinden. Zudem wird ein Einschalten eines parasitären npn-Transistors, gebildet aus den Bereichen 8, 6 und 2, durch die vom Avalanchedurchbruch generierten Löcher vermieden.

Mit diesen Maßnahmen erhält man Pseudo-Schottky-Dioden, deren Flussspannungen mit den Flussspannungen von Hocheffizienz-Schottky-Dioden vergleichbar sind, die des Weiteren aber auch als stabile Z-Dioden wirken.

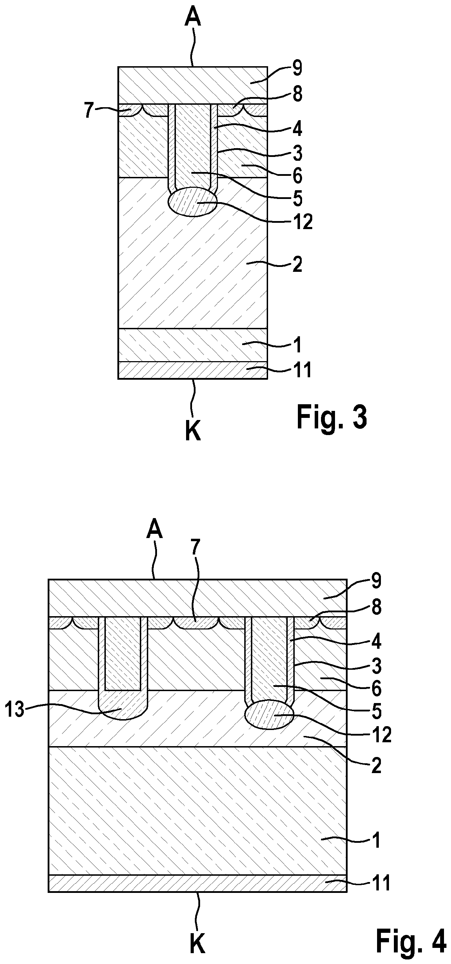

Eine weitere, einfachere Pseudo-Schottky-Diode, die das Verständnis der vorliegenden Erfindung erleichtert, ist in Fig.3 abgebildet. Im Unterschied zu der in der Figur 1 gezeigten Pseudo-Schottky-Diode wird dabei auf die dicke dielektrische Schicht 10 und die in Fig.1 nicht eingezeichnete Kontaktstelle verzichtet. Dafür wird die Polysiliziumschicht 5 direkt mit der Metallschicht 9 und damit auch mit den p+- und n+-dotierten Schichten 7 und 8 verbunden.

Da die weiteren p-dotierten Gebiete 12 unterhalb der Gräbenböden auch etwas lateral ausdiffundieren, wird der Querschnitt des Stromflusses in Vorwärtsrichtung an dieser Stelle geringfügig verringert. Dies führt bei hohen Stromdichten zu einer Erhöhung der Durchlassspannung UON. Dies kann, wie in einem weiteren Beispiel gemäß Fig.4 gezeigt ist, dadurch abgemildert werden, dass man nicht jede Zelle mit einem weiteren p-Gebiet 12 am Grabenboden versieht, sondern beispielsweise nur jede zweite oder dritte Zelle. Allerdings sind an den Zellen, die keine weiteren p-dotierten Bereiche 12 aufweisen, die Felder an der dünnen Gateoxidschicht 4 im Bereich des jeweiligen Grabenbodens sehr hoch. Die dünne Dimensionierung der Gateoxidschichten 4 ist dadurch bedingt, dass die Schwellenspannung einer Pseudo-Schottky-Diode klein ist. Dies kann zu Beschädigungen und Frühausfällen der Gateoxidschichten 4 führen. Aus diesem Grund wird vorgeschlagen, die an den Gräbenböden vorgesehenen Gateoxidschichten 13 dicker auszuführen als die Gateoxidschichten 4 an den Seitenwänden der Gräben.

Pseudo-Schottky-Dioden mit den erfindungsgemäßen Merkmalen können in vorteilhafter Weise in Kraftfahrzeuggeneratoren als Gleichrichterelemente verwendet werden. Insbesondere eignen sich derartige Pseudo-Schottky-Dioden auch zu einer Verwendung in Kraftfahrzeugwechselstromgeneratoren, welche mehr als drei Phasen aufweisen.

## Patentansprüche

1. Pseudo-Schottky-Diode, die einen n-Kanal-Trench-MOS-Feldeffekttransistor aufweist, welcher eine Kathode (K), eine Anode (A) und zwischen der Kathode und der Anode ein hoch n⁺-dotiertes Siliziumsubstrat (1), eine n-dotierte Epischicht (2), sich in die n-dotierte Epischicht (2) erstreckende Gräben (3), zwischen den Gräben (3) vorgesehene, p-dotierte Bodygebiete (6) sowie an der Oberfläche der Bodygebiete (6) vorgesehene hoch n⁺-dotierte Bereiche (8) aufweist, wobei das Gate, die Bodygebiete und das Sourcegebiet monolithisch und elektrisch miteinander verbunden sind und bei welchem das Draingebiet als Kathode dient, worin an den Seitenrändern der Gräben (3) dielektrische Schichten (4) vorgesehen sind, die Gräben (3) mit einer Polysiliziumschicht (5) gefüllt sind, die Böden eines Teils der Gräben (3) von einer mit der p-dotierten Polysiliziumschicht (5) kontaktierten weiteren p-dotierten Schicht (12) gebildet sind, **dadurch gekennzeichnet, dass** sich die weiteren p-dotierten Schichten (12) bis in das hoch n⁺-dotierte Siliziumsubstrat (1) erstrecken, dass der pn-Übergang der weiteren p-dotierten Schichten (12) zum hoch n⁺-dotiertes Siliziumsubstrat (1) die Durchbruchsspannung der Pseudo-Schottky-Diode bestimmt,
dass die Polysiliziumschicht (5) p-dotiert ist,
und dass die Pseudo-Schottky-Diode an der Oberfläche der Bodygebiete (6) vorgesehene p⁺-dotierte Bereiche (7) aufweist.

2. Pseudo-Schottky-Diode nach Anspruch 1, **dadurch gekennzeichnet, dass** die an den Seitenwänden der Gräben (3) vorgesehenen dielektrischen Schichten (4) jeweils eine Dicke (tox) aufweisen, die kleiner ist als 15 nm.

3. Pseudo-Schottky-Diode nach Anspruch 2, **dadurch gekennzeichnet, dass** ihre Schwellenspannung kleiner ist als 350 mV.

4. Pseudo-Schottky-Diode nach einem der vorhergehenden Ansprüche, **dadurch gekennzeichnet, dass** die Böden aller Gräben (3) von einem mit der dotierten Polysiliziumschicht (5) kontaktierten weiteren p-dotierten Schicht (12) gebildet sind.

5. Pseudo-Schottky-Diode nach einem der Ansprüche 1 - 3, **dadurch gekennzeichnet, dass** sie sowohl Gräben aufweist, deren Böden von einem mit der dotierten Polysiliziumschicht (5) kontaktierten weiteren p-dotierten Schicht (12) gebildet sind, als auch Gräben aufweist, deren Böden von einer mit der dotierten Polysiliziumschicht (5) kontaktierten Oxidschicht (13) gebildet sind.

6. Pseudo-Schottky-Diode nach Anspruch 5, **dadurch gekennzeichnet, dass** die die Böden bildende Oxidschicht (13) dicker ist als die an den Seitenwänden der Gräben vorgesehenen Oxidschichten (4).

7. Pseudo-Schottky-Diode nach einem der vorhergehenden Ansprüche, **dadurch gekennzeichnet, dass** ihre Durchbruchspannung bei Strömen im Bereich von 1 mA bis 100 mA zwischen 20 V und 50 V liegt.

8. Pseudo-Schottky-Diode nach einem der vorhergehenden Ansprüche, **dadurch gekennzeichnet, dass** ihre Einsatzspannung (UON) kleiner ist als 0,8 V, wenn sie von einem Strom durchflossen ist, dessen Stromdichte 500 A/cm² beträgt.

9. Pseudo-Schottky-Diode nach Anspruch 8, **dadurch gekennzeichnet, dass** ihre Einsatzspannung (UON) zwischen 0,5 V und 0,7 V liegt, wenn sie von einem Strom durchflossen ist, dessen Stromdichte 500 A/cm² beträgt.

10. Pseudo-Schottky-Diode nach einem der vorhergehenden Ansprüche, **dadurch gekennzeichnet, dass** sie eine lötbare Vorderseite und eine lötbare Rückseite aufweist.

11. Kraftfahrzeuggenerator, welcher Pseudo-Schottky-Dioden nach einem oder mehreren der Ansprüche 1 - 10 aufweist.

12. Kraftfahrzeugwechselstromgenerator, welcher mehr als drei Phasen aufweist und welcher Pseudo-Schottky-Dioden nach einem oder mehreren der Ansprüche 1 - 10 aufweist.

## Claims

1. Pseudo-Schottky diode comprising an n-channel trench MOS field effect transistor comprising a cathode (K), an anode (A) and, between the cathode and the anode, a highly n⁺-doped silicon substrate (1), an n-doped epitaxial layer (2), trenches (3) extending into the n-doped epitaxial layer (2), p-doped body regions (6) provided between the trenches (3), and highly n⁺-doped regions (8) provided at the surface of the body regions (6), wherein the gate, the body regions and the source region are monolithically and electrically connected to one another and wherein the drain region serves as cathode, wherein dielectric layers (4) are provided at the side edges of the trenches (3), the trenches (3) are filled with a polysilicon layer (5), the bottoms of a portion of the trenches (3) are formed by a further p-doped layer (12) contacted with the p-doped polysilicon layer (5), **characterized in that** the further p-doped layers (12) extend right into the highly n⁺-doped silicon substrate (1), **in that** the pn junction between the further p-doped layers (12) and the highly n⁺-doped silicon substrate (1) determines the breakdown voltage of the pseudo-Schottky diode, **in that** the polysilicon layer (5) is p-doped, and **in that** the pseudo-Schottky diode comprises p⁺-doped regions (7) provided at the surface of the body regions (6).

2. Pseudo-Schottky diode according to Claim 1, **characterized in that** the dielectric layers (4) provided at the sidewalls of the trenches (3) each have a thickness (tox) that is less than 15 nm.

3. Pseudo-Schottky diode according to Claim 2, **characterized in that** its threshold voltage is less than 350 mV.

4. Pseudo-Schottky diode according to any of the preceding claims, **characterized in that** the bottoms of all the trenches (3) are formed by a further p-doped layer (12) contacted with the doped polysilicon layer (5).

5. Pseudo-Schottky diode according to any of Claims 1-3, **characterized in that** it comprises both trenches whose bottoms are formed by a further p-doped layer (12) contacted with the doped polysilicon layer (5), and trenches whose bottoms are formed by an oxide layer (13) contacted with the doped polysilicon layer (5).

6. Pseudo-Schottky diode according to Claim 5, **characterized in that** the oxide layer (13) forming the bottoms is thicker than the oxide layers (4) provided at the sidewalls of the trenches.

7. Pseudo-Schottky diode according to any of the preceding claims, **characterized in that** its breakdown voltage in the case of currents in the range of 1 mA to 100 mA is between 20 V and 50 V.

8. Pseudo-Schottky diode according to any of the preceding claims, **characterized in that** its turn-on voltage (UON) is less than 0.8 V if a current whose current density is 500 A/cm² flows through it.

9. Pseudo-Schottky diode according to Claim 8, **characterized in that** its turn-on voltage (UON) is between 0.5 V and 0.7 V if a current whose current density is 500 A/cm² flows through it.

10. Pseudo-Schottky diode according to any of the preceding claims, **characterized in that** it has a solderable front side and a solderable rear side.

11. Motor vehicle generator comprising pseudo-Schottky diodes according to one or more of Claims 1-10.

12. Motor vehicle AC generator comprising more than three phases and comprising pseudo-Schottky diodes according to one or more of Claims 1-10.

## Revendications

1. Diode pseudo-Schottky, laquelle possède un transistor à effet de champ MOS à tranchée de canal N, qui possède une cathode (K), une anode (A) et, entre la cathode et l'anode, un substrat en silicium à fort dopage N⁺ (1), une couche épitaxiale dopée N (2), des tranchées (3) qui s'étendent dans la couche épitaxiale dopée N (2), des régions de corps dopées P (6) disposées entre les tranchées (3) ainsi que des zones à fort dopage N⁺ (8) prévues à la surface des régions de corps (6), la gâchette, les régions de corps et la région de source étant monolithiques et reliées électriquement entre elles et avec lequel la région de drain sert de cathode, où des couches diélectriques (4) se trouvent au niveau des bords latéraux des tranchées (3), les tranchées (3) sont remplies d'une couche de polysilicium (5), les fonds d'une partie des tranchées (3) sont formées par une couche dopée P (12) supplémentaire qui entre en contact avec la couche de polysilicium dopée P (5), **caractérisée en ce que** les couches dopées P (12) supplémentaires s'étendent jusque dans le substrat en silicium à fort dopage N⁺ (1), **en ce que** la transition PN des couches dopées P (12) supplémentaires vers le substrat en silicium à fort dopage N⁺ (1) détermine la tension de claquage de la diode pseudo-Schottky, **en ce que** la couche de polysilicium (5) est dopée P et **en ce que** la diode pseudo-Schottky possède des zones dopées P⁺ (7) prévues à la surface des régions de corps (6).

2. Diode pseudo-Schottky selon la revendication 1, **caractérisée en ce que** les couches diélectriques (4) présentes au niveau des parois latérales des tranchées (3) possèdent respectivement une épaisseur (tox) qui est inférieure à 15 nm.

3. Diode pseudo-Schottky selon la revendication 2, **caractérisée en ce que** sa tension de seuil est inférieure à 350 mV.

4. Diode pseudo-Schottky selon l'une des revendications précédentes, **caractérisée en ce que** les fonds de toutes les tranchées (3) sont formés par une couche dopée P (12) supplémentaire qui entre en contact avec la couche de polysilicium dopée (5).

5. Diode pseudo-Schottky selon l'une des revendications 1 à 3, **caractérisée en ce qu'**elle possède à la fois des tranchées dont les fonds sont formés par une couche dopée P (12) supplémentaire qui entre en contact avec la couche de polysilicium dopée (5) et des tranchées dont les fonds sont formés par une couche d'oxyde (13) qui entre en contact avec la couche de polysilicium dopée (5).

6. Diode pseudo-Schottky selon la revendication 5, **caractérisée en ce que** la couche d'oxyde (13) qui forme les fonds est plus épaisse que les couches d'oxyde (4) se trouvant au niveau des parois latérales des tranchées.

7. Diode pseudo-Schottky selon l'une des revendications précédentes, **caractérisée en ce que** sa tension de claquage avec des courants dans la plage de 1 mA à 100 mA est comprise entre 20 V et 50 V.

8. Diode pseudo-Schottky selon l'une des revendications précédentes, **caractérisée en ce que** sa tension de blocage (UON) est inférieure à 0,8 V lorsqu'elle est traversée par un courant dont la densité de courant est de 500 A/cm².

9. Diode pseudo-Schottky selon la revendication 8, **caractérisée en ce que** sa tension de blocage (UON) est comprise entre 0,5 V et 0,7 V lorsqu'elle est traversée par un courant dont la densité de courant est de 500 A/cm².

10. Diode pseudo-Schottky selon l'une des revendications précédentes, **caractérisée en ce qu'**elle possède un côté avant pouvant être brasé et un côté arrière pouvant être brasé.

11. Générateur pour véhicule automobile, lequel possède des diodes pseudo-Schottky selon l'une ou plusieurs des revendications 1 à 10.

12. Générateur de courant alternatif pour véhicule automobile, lequel possède plus de trois phases et lequel possède des diodes pseudo-Schottky selon l'une ou plusieurs des revendications 1 à 10.
